# EUROPEAN PATENT APPLICATION

(11) **EP 4 801 215 A1**
(43) Date of publication of application: **02.09.2026**
(21) Application number: 24882356.9
(22) Date of filing: 21.10.2024
(51) Int. Cl.: H05K 9/00, C01B 32/168, C01B 32/174

(54) **ELECTROMAGNETIC WAVE ABSORBING MEMBER FOR SUB-TERAHERTZ FREQUENCY BAND OF 100 GHZ OR HIGHER**

(30) Priority: 25.10.2023 JP 2023183505
(71) Applicant: Zeon Corporation, Tokyo 100-8246 (JP)
(72) Inventor: YATSUZUKA Taichi, Tokyo 100-8246 (JP); YAMAGISHI Tomoko, Tokyo 100-8246 (JP)
(74) Representative: Maiwald GmbH
(86) International application number: PCT/JP2024/037453
(87) International publication number: WO 2025/089243

(57) **Abstract**

An electromagnetic wave absorbing member for a sub-terahertz frequency band contains a polymer material and carbon nanotubes, wherein the carbon nanotubes include single-walled carbon nanotubes as a main component, and the electromagnetic wave absorbing member has an electrical conductivity of not less than 0.1 S/cm and not more than 2.0 S/cm and has an attenuation power ratio of 5 dB or more at a frequency of 300 GHz.

## Description

### TECHNICAL FIELD

The present disclosure relates to an electromagnetic wave absorbing member for a sub-terahertz frequency band of 100 GHz or higher.

### BACKGROUND

The use of composite materials having an electrically conductive material, such as carbon nanotubes (hereinafter, also referred to as "CNTs"), compounded in an electrically insulating material, such as a resin, for electromagnetic wave absorbing materials in electrical, communications, and other such fields is known in the art. In these fields, the operating frequency differs depending on the application, However, in actual use environments, electromagnetic waves of frequency regions other than a required frequency region often arise as noise. This has created the need for electromagnetic wave absorbing materials that are capable of attenuating electromagnetic waves of an unwanted frequency without attenuating electromagnetic waves of a required frequency.

For example, Patent Literature (PTL) 1 discloses an electromagnetic wave absorbing sheet that includes a sheet-shaped fibrous substrate and single-walled CNTs positioned inside of this sheet-shaped substrate and that has an electrical conductivity of 0.7 S/cm to 20 S/cm. PTL 1 discloses that this electromagnetic wave absorbing sheet has a transmission attenuation power ratio of 20 dB or more in at least part of a range of not lower than 1 GHz and not higher than 10 GHz.

### CITATION LIST

### Patent Literature

PTL 1: WO2020/067203A1

### SUMMARY

### (Technical Problem)

In recent years, there has been demand for electromagnetic wave absorption performance in a 6G band (sub-terahertz frequency band of 100 GHz or higher). However, up to the present, inclusive of PTL 1 described above, CNT-containing electromagnetic wave absorbing sheets that are capable of displaying electromagnetic wave absorption performance in a sub-terahertz frequency band have not been adequately studied.

An object of the present disclosure is to provide an electromagnetic wave absorbing member having excellent electromagnetic wave absorption performance in a sub-terahertz frequency band of 100 GHz or higher.

### (Solution to Problem)

The inventors conducted diligent studies to solve the problem described above. The inventors made a new discovery that in an electromagnetic wave absorbing member that contains a polymer material and carbon nanotubes, when the carbon nanotubes include single-walled carbon nanotubes as a main component and when the electrical conductivity of the electromagnetic wave absorbing member is within a specific range, it is possible to increase the attenuation power ratio in a sub-terahertz frequency band of 100 GHz or higher, and, in this manner, the inventors completed the present disclosure.

Specifically, with the aim of advantageously solving the problem set forth above, a presently disclosed electromagnetic wave absorbing member for a sub-terahertz frequency band is [1] an electromagnetic wave absorbing member comprising a polymer material and carbon nanotubes, wherein the carbon nanotubes include single-walled carbon nanotubes as a main component, and the electromagnetic wave absorbing member has an electrical conductivity of not less than 0.1 S/cm and not more than 2.0 S/cm and has an attenuation power ratio of 5 dB or more at a frequency of 300 GHz. When single-walled carbon nanotubes are used as a main component and electrical conductivity is set within the range set forth above, this enables the display of electromagnetic wave absorption performance in a sub-terahertz frequency band of 100 GHz or higher.

Note that the electrical conductivity and attenuation power ratio can be measured by methods described in the EXAMPLES section.

[2] In the electromagnetic wave absorbing member according to the foregoing [1], an attached amount of the carbon nanotubes is A, in units of mg, an electrical conductivity of the carbon nanotubes is C, in units of S/cm, and an index value I determined according to formula (1), shown below:

Index value I = C × A ··· (1)

is preferably not less than 40 and not more than 500.

When the index value I is within the range set forth above, this results in even better electromagnetic wave absorption performance in a sub-terahertz frequency band. Note that the "electrical conductivity of carbon nanotubes" referred to in the present specification means the electrical conductivity measured with respect to buckypaper formed using a specific amount of CNTs as described in the EXAMPLES section.

[3] In the electromagnetic wave absorbing member according to the foregoing [1] or [2], the electromagnetic wave absorbing member is preferably formed as a single-layer sheet. When the electromagnetic wave absorbing member is a single-layer sheet, this enables reduction of thickness and weight of the electromagnetic wave absorbing member.

[4] In the electromagnetic wave absorbing member according to any one of the foregoing [1] to [3], the electromagnetic wave absorbing member preferably has a thickness of 300 µm or less. When the thickness of the electromagnetic wave absorbing member is not more than the upper limit set forth above, the electromagnetic wave absorbing member can suitably be used in mobile terminals such as smartphones and tablets, automobiles, base stations, medical devices, and various applications where space saving is necessary.

Note that the thickness of an electromagnetic wave absorbing member can be measured by a method described in the EXAMPLES section.

[5] In the electromagnetic wave absorbing member according to any one of the foregoing [1] to [3], the electromagnetic wave absorbing member preferably has a configuration that includes a polymer sheet containing the polymer material and that includes the carbon nanotubes attached to the polymer sheet. By causing the carbon nanotubes to attach to a polymer sheet, it is possible to restrict electrical conductivity and increase electromagnetic wave absorption performance.

[6] In the electromagnetic wave absorbing member according to any one of the foregoing [1] to [3], the electromagnetic wave absorbing member is preferably a sheet that has been formed from a composition containing the polymer material and the carbon nanotubes.

[7] In the electromagnetic wave absorbing member according to the foregoing [5], the polymer sheet is preferably non-woven fabric that has been formed using polymer fibers formed of the polymer material. By using non-woven fabric that is obtained using polymer fibers formed of the polymer material, it is possible to restrict electrical conductivity and increase electromagnetic wave absorption performance.

[8] In the electromagnetic wave absorbing member according to any one of the foregoing [1] to [7], the carbon nanotubes preferably have a G/D ratio of 4.0 or less. When the G/D ratio of the carbon nanotubes is not more than the upper limit set forth above, it is easy to control electrical conductivity.

Note that the G/D ratio refers to a ratio of G band peak intensity relative to D band peak intensity in a Raman spectrum and that the G/D ratio of carbon nanotubes can be measured by a method described in the EXAMPLES section.

[9] In the electromagnetic wave absorbing member according to any one of the foregoing [1] to [8], the carbon nanotubes preferably have a BET specific surface area of 600 m²/g or more. When the BET specific surface area of the carbon nanotubes is not less than the lower limit set forth above, this results in even better electromagnetic wave absorption performance in a sub-terahertz frequency band.

Note that the "BET specific surface area" referred to in the present specification means the nitrogen adsorption specific surface area measured by the BET (Brunauer-Emmett-Teller) method.

[10] In the electromagnetic wave absorbing member according to any one of the foregoing [1] to [9], the carbon nanotubes preferably have an effective length of not less than 40 nm and not more than 1,000 nm. When the effective length of the carbon nanotubes is within the range set forth above, this enables further improvement of a balance of film properties and electromagnetic wave absorption capability of an electromagnetic wave absorbing material in a high frequency region.

Note that the effective length of carbon nanotubes can be measured by a method described in the EXAMPLES section.

[11] In the electromagnetic wave absorbing member according to any one of the foregoing [1] to [10], the electromagnetic wave absorbing member preferably has an attenuation power ratio of 5 dB or more throughout a frequency band of not lower than 200 GHz and not higher than 300 GHz. When the attenuation power ratio is 5 dB or more throughout the frequency band set forth above, this results in even better electromagnetic wave absorption performance in a sub-terahertz frequency band.

### (Advantageous Effect)

According to the present disclosure, it is possible to provide an electromagnetic wave absorbing member having excellent electromagnetic wave absorption performance in a sub-terahertz frequency band of 100 GHz or higher.

### DETAILED DESCRIPTION

The following provides a detailed description of embodiments of the present disclosure.

### (Electromagnetic wave absorbing member)

The presently disclosed electromagnetic wave absorbing member is an electromagnetic wave absorbing member containing a polymer material and carbon nanotubes, wherein the carbon nanotubes include single-walled carbon nanotubes as a main component, and the electromagnetic wave absorbing member has an electrical conductivity of not less than 0.1 S/cm and not more than 2.0 S/cm and has an attenuation power ratio of 5 dB or more at a frequency of 300 GHz. The presently disclosed electromagnetic wave absorbing member may optionally contain other components such as additives that have been used in production of the electromagnetic wave absorbing member. Moreover, the presently disclosed electromagnetic wave absorbing member can display excellent electromagnetic wave absorption performance in a sub-terahertz frequency band of 100 GHz or higher.

Although the reason for this is not clear, it is presumed to be as follows. Specifically, electromagnetic waves are reflected by a member without being absorbed if the electrical conductivity is excessively high. Therefore, by using a polymer material and carbon nanotubes in combination, it is possible to restrict electrical conductivity to a suitable level and obtain a member that has high absorption performance instead of reflecting electromagnetic waves. The assumed mechanism described above is thought to enable an electromagnetic wave absorbing member that satisfies the specific properties set forth above to display excellent electromagnetic wave absorption performance in a sub-terahertz frequency band.

Note that the upper limit frequency of a "sub-terahertz frequency band" that is a target of the presently disclosed electromagnetic wave absorbing member is normally 1 THz. Also note that in the EXAMPLES section of the present specification, an electromagnetic wave attenuation power ratio of 5 dB or more as measured in a frequency band of not lower than 200 GHz and not higher than 300 GHz, which is within a range of not lower than 100 GHz and not higher than 1 THz constituting this sub-terahertz frequency band, was judged to indicate that an electromagnetic wave absorbing member has excellent electromagnetic wave absorption performance in a sub-terahertz frequency band.

### <Composition of electromagnetic wave absorbing member>

### <<Polymer material>>

Known resins and electrically insulating fillers can be used as the polymer material according to the application of the electromagnetic wave absorbing material without any specific limitations. Specifically, an electrically insulating material obtained by optionally mixing an electrically insulating filler with a resin can be used. Note that rubbers and elastomers are considered to be encompassed by the term "resin" as used in the present disclosure. Moreover, organic fibers can suitably be used as the polymer material.

### [Resin]

Examples of resins that may be used include natural rubber (inclusive of epoxidized natural rubber), diene synthetic rubber (butadiene rubber, epoxidized butadiene rubber, styrene butadiene rubber, acrylonitrile butadiene rubber, ethylene vinyl acetate rubber, chloroprene rubber, vinylpyridine rubber, butyl rubber, chlorobutyl rubber, and polyisoprene rubber), ethylene propylene rubber (EPR, EPDM), acrylic rubber, silicone rubber, epichlorohydrin rubber (CO, ECO), urethane rubber, polysulfide rubber, fluororubber, fluororesin, urea resin, melamine resin, phenolic resin, cellulosic resin such as cellulose acetate, cellulose nitrate, and cellulose acetate butyrate; casein plastic; soy protein plastic; benzoguanamine resin; epoxy resin such as bisphenol A-type epoxy resin, novolac-type epoxy resin, and polyfunctional epoxy resin; diallyl phthalate resin; alkyd resin; polyvinyl chloride resin; polyethylene resin; polypropylene resin; styrenic resin such as ABS (acrylonitrile butadiene styrene) resin, AS (acrylonitrile styrene) resin, and polystyrene; acrylic resin; methacrylic resin; organic acid vinyl ester resin such as polyvinyl acetate; vinyl ether resin; halogen-containing resin; polycycloolefin resin; olefin resin; alicyclic olefin resin; polycarbonate resin; polyester resin (inclusive of unsaturated polyester resin); polyamide resin; thermoplastic and thermosetting polyurethane resin; polysulfone resin; polyphenylene ether resin (inclusive of modified polyphenylene ether resin); silicone resin; polyacetal resin; polyimide resin; polyethylene terephthalate resin; polybutylene terephthalate resin; polyarylate resin; polyphenylene sulfide resin; and polyether ether ketone resin. One of these resins may be used individually, or two or more of these resins may be used as a mixture.

### [Electrically insulating filler]

Known inorganic fillers and organic fillers that are electrically insulating can be used as the electrically insulating filler without any specific limitations. Examples of such electrically insulating fillers include silica, talc, clay, titanium oxide, nylon fibers, Vinylon fibers, acrylic fibers, and rayon fibers. One of these fillers may be used individually, or two or more of these fillers may be used as a mixture.

### [Organic fibers]

Examples of organic fibers that may be used include, but are not specifically limited to, synthetic fibers formed of polymers such as polyvinyl alcohol, Vinylon, polyethylene vinyl alcohol, polyethylene glycol, polyvinylpyrrolidone, poly-ε-caprolactone, polyacrylonitrile, polylactic acid, polycarbonate, polyamide, polyimide, polyethylene, polypropylene, polyethylene terephthalate, and modified products thereof; and natural fibers such as cotton, hemp, wool, and silk. The polymer forming synthetic fibers can be a single polymer used individually or a mixture of a plurality of polymers.

It should be noted that carbon nanotubes are considered to not be included among the organic fibers described above.

### <<Carbon nanotubes>>

The carbon nanotubes (hereinafter, also referred to as CNTs) that are contained in the presently disclosed electromagnetic wave absorbing member include single-walled carbon nanotubes (single-walled CNTs) as a main component. Examples of components other than single-walled CNTs that can be included among the CNTs include multi-walled carbon nanotubes (multi-walled CNTs). The proportion constituted by single-walled CNTs among the total mass of the CNTs is required to be more than 50 mass%, is preferably 90 mass% or more, and more preferably 95 mass% or more, and may be 100 mass%. Note that in a case in which the CNTs include multi-walled CNTs, the number of walls in the multi-walled CNTs is preferably 5 or less.

Preferred attributes of the CNTs are described below. These attributes preferably apply to both CNTs that are used as a material in production of the presently disclosed electromagnetic wave absorbing member and also CNTs that are contained in the presently disclosed electromagnetic wave absorbing member.

### [BET specific surface area]

The BET specific surface area of the CNTs is preferably 600 m²/g or more, more preferably 800 m²/g or more, and even more preferably 1,000 m²/g or more, and is preferably 2,000 m²/g or less, more preferably 1,800 m²/g or less, and even more preferably 1,600 m²/g or less. When the BET specific surface area is within any of the ranges set forth above, the electromagnetic wave absorbing member can display even better electromagnetic wave absorption performance in a sub-terahertz frequency band. Note that the "BET specific surface area" referred to in the present disclosure means the nitrogen adsorption specific surface area measured by the BET (Brunauer-Emmett-Teller) method.

### [G/D ratio]

The G/D ratio of the CNTs is preferably 4.0 or less, more preferably 3.5 or less, and even more preferably 3.0 or less, and is preferably 0.8 or more, and more preferably 1.0 or more. When the G/D ratio is not more than any of the upper limits set forth above, this makes it easy to control electrical conductivity and results in even better electromagnetic wave absorption performance.

### [Effective length]

The effective length of the CNTs is preferably 40 nm or more, and more preferably 50 nm or more, and is preferably 1,000 nm or less, and more preferably 300 nm or less. When the effective length is within any of the ranges set forth above, this enables further improvement of a balance of film properties and electromagnetic wave absorption capability of an electromagnetic wave absorbing material in a high frequency region.

Note that in the case of a CNT that does not have a completely straight shape and in which there are a plurality of bent sections (kinks) partway along the longitudinal direction, the effective length of the CNT referred to in the present disclosure indicates the distance between adjacent kinks.

### [Average diameter and average length]

The average diameter of the CNTs is preferably 1 nm or more, and is preferably 60 nm or less, more preferably 30 nm or less, and even more preferably 10 nm or less.

Moreover, the average length of the CNTs is preferably 10 µm or more, more preferably 50 µm or more, even more preferably 80 µm or more, and particularly preferably 200 µm or more, and is preferably 600 µm or less, more preferably 500 µm or less, and even more preferably 450 µm or less.

When CNTs having an average diameter and/or average length that is within any of the ranges set forth above are used to produce a dispersion liquid, the CNTs are present uniformly in the dispersion liquid, and such CNTs make it possible to obtain an electromagnetic wave absorbing member that is homogeneous and has even better electromagnetic wave absorption performance in a sub-terahertz frequency band of 100 GHz or higher.

### [Purity]

The purity of the CNTs is preferably 98 mass% or more, and more preferably 99 mass% or more. Almost no impurities are present in such a CNT assembly, and various intrinsic characteristics of the CNTs can be sufficiently displayed. Note that although no specific limitations are placed on the upper limit for the purity of the CNTs, it is difficult to obtain a CNT assembly having a purity of 99.9999 mass% or more from a production viewpoint. The purity of the CNTs can be determined through elemental analysis using X-ray fluorescence, thermogravimetric analysis (TGA), or the like.

### [Aspect ratio]

The CNTs normally have an aspect ratio (length/diameter) of more than 10.

The average diameter, average length, and aspect ratio of the CNTs can be determined by measuring the diameters and lengths of 100 randomly selected CNTs using a scanning electron microscope or a transmission electron microscope.

A t-plot for the CNTs obtained from an adsorption isotherm preferably exhibits a convex upward shape.

The growth of an adsorbed layer of nitrogen gas for a substance having pores at the surface is divided into the following processes (1) to (3). The gradient of the t-plot changes in accordance with processes (1) to (3).
(1) A process in which a single molecular adsorption layer is formed over the entire surface by nitrogen molecules
(2) A process in which a multi-molecular adsorption layer is formed and is accompanied by capillary condensation filling of pores
(3) A process in which a multi-molecular adsorption layer is formed at a surface that appears to be non-porous due to the pores being filled by nitrogen

In a t-plot having a convex upward shape, the plot is on a straight line passing through the origin in a region in which the average adsorbed nitrogen gas layer thickness t is small, but, as t increases, the plot deviates downward from the straight line. When CNTs have a t-plot shape such as described above, this indicates that the ratio of internal specific surface area relative to total specific surface area of the CNTs is large and that numerous openings are formed in the CNTs. As a result, when such CNTs are used to produce a dispersion liquid, the CNTs do not tend to aggregate in the dispersion liquid, and an electromagnetic wave absorbing member that is homogeneous and has even better electromagnetic wave absorption performance in a sub-terahertz frequency band can be obtained.

A bending point of the t-plot of the CNTs is preferably within a range of 0.2 ≤ t (nm) ≤ 1.5, more preferably within a range of 0.45 ≤ t (nm) ≤ 1.5, and even more preferably within a range of 0.55 ≤ t (nm) ≤ 1.0. When CNTs having a t-plot with a bending point that is within any of these ranges are used to produce a dispersion liquid, the CNTs have an even lower tendency to aggregate in the dispersion liquid. As a result, it is possible to obtain an electromagnetic wave absorbing member that is even more homogeneous and has even better electromagnetic wave absorption performance in a sub-terahertz frequency band.

The "position of the bending point" is an intersection point of a linear approximation A for the above-described process (1) and a linear approximation B for the above-described process (3).

A ratio (S2/S1) of internal specific surface area S2 relative to total specific surface area S1 of the CNTs determined from a t-plot is preferably not less than 0.05 and not more than 0.30. When CNTs having a value of S2/S1 that is within this range are used to produce a dispersion liquid, the CNTs have an even lower tendency to aggregate in the dispersion liquid. As a result, it is possible to obtain an electromagnetic wave absorbing member that is even more homogeneous and has even better electromagnetic wave absorption performance in a sub-terahertz frequency band.

The total specific surface area S1 and internal specific surface area S2 of the CNTs can be determined from a t-plot for the CNTs. Specifically, the total specific surface area S1 and external specific surface area S3 can first be determined from the gradient of the linear approximation of process (1) and the gradient of the linear approximation of process (3), respectively. The internal specific surface area S2 can then be calculated by subtracting the external specific surface area S3 from the total specific surface area S1.

Measurement of an adsorption isotherm of the CNTs, preparation of a t-plot, and calculation of the total specific surface area S1 and internal specific surface area S2 based on analysis of the t-plot can be performed, for example, using a BELSORP^{®}-mini (BELSORP is a registered trademark in Japan, other countries, or both), which is a commercially available measurement instrument produced by Bel Japan Inc.

The CNTs can be produced by a known CNT synthesis method such as arc discharge, laser ablation, or chemical vapor deposition (CVD) without any specific limitations. Specifically, the CNTs can be efficiently produced in accordance with a method (super growth method; refer to WO2006/011655A1) in which during synthesis of CNTs through chemical vapor deposition (CVD) by supplying a feedstock compound and a carrier gas onto a substrate having a catalyst layer for carbon nanotube production at the surface thereof, a trace amount of an oxidant (catalyst activating material) is provided in the system so as to dramatically improve catalytic activity of the catalyst layer, for example. Hereinafter, carbon nanotubes that are obtained by the super growth method are also referred to as "SGCNTs".

The CNTs that are contained in the electromagnetic wave absorbing member may originate from a CNT assembly that satisfies at least one of the following conditions (1) to (3) (for example, refer to WO2022/114237A1).
(1) In a spectrum obtained by Fourier-transform infrared spectroscopy with respect to a carbon nanotube dispersion obtained by dispersing the carbon nanotube assembly such as to have a bundle length of 10 µm or more, at least one peak based on plasmon resonance of the carbon nanotube dispersion is present in a wavenumber range of more than 300 cm⁻¹ and not more than 2000 cm⁻¹.
(2) On a pore distribution curve for the carbon nanotube assembly indicating a relationship between pore diameter and Log differential pore volume that is obtained based on the Barrett-Joyner-Halenda method from an adsorption isotherm of liquid nitrogen at 77 K, a largest peak is in a pore diameter range of more than 100 nm and less than 400 nm.
(3) In a two-dimensional spatial frequency spectrum of an electron microscope image of the carbon nanotube assembly, at least one peak is present in a range of not less than 1 cm⁻¹ and not more than 100 cm⁻¹.

A CNT assembly satisfying the specific attributes described above can be produced according to a production method described in WO2022/114237A1.

### [Content]

The content of the carbon nanotubes in the presently disclosed electromagnetic wave absorbing member depends on the electrical conductivity of the carbon nanotubes but is preferably 0.1 mg/cm² or more, and more preferably 0.2 mg/cm² or more, and is preferably 2.0 mg/cm² or less, and more preferably 1.5 mg/cm² or less. When the content of the CNTs in the electromagnetic wave absorbing member is not less than any of the lower limits set forth above, the electromagnetic wave absorbing member can display even better electromagnetic wave absorption performance in a sub-terahertz frequency band of 100 GHz or higher because the electromagnetic wave absorbing member can display suitably high electrical conductivity. On the other hand, when the mass per unit area of the CNTs in the electromagnetic wave absorbing member is not more than any of the upper limits set forth above, the electromagnetic wave absorbing member has a low tendency to reflect electromagnetic waves, and electromagnetic wave absorption capability can be even further increased. Consequently, the electromagnetic wave absorbing member can display even better electromagnetic wave absorption performance in a sub-terahertz frequency band.

Note that in a situation in which the electromagnetic wave absorbing member is an electromagnetic wave absorbing sheet as described further below, the content of the CNTs in the electromagnetic wave absorbing sheet can be measured by a method described in the EXAMPLES section.

Moreover, the content of the CNTs in the electromagnetic wave absorbing sheet can be adjusted by altering various conditions in production of the electromagnetic wave absorbing sheet.

When the attached amount of the carbon nanotubes in the presently disclosed electromagnetic wave absorbing member is taken to be A mg, an index value I determined according to the following formula (1) with respect to A (mg) and the electrical conductivity C (S/cm) of buckypaper of 38 mm in diameter that is produced using 20 mg of the CNTs used to form the presently disclosed electromagnetic wave absorbing member (this electrical conductivity is referred to as the "electrical conductivity of the CNTs" in the present specification) is preferably not less than 40 and not more than 500, and more preferably not less than 70 and not more than 300. When the index value I is within any of the ranges set forth above, this results in even better electromagnetic wave absorption performance in a sub-terahertz frequency band. $I = C \left(S/cm\right) \times A \left(mg\right)$

Note that production of buckypaper and measurement of the electrical conductivity of CNTs can be performed by methods described in the EXAMPLES section.

### <Shape of electromagnetic wave absorbing member>

The presently disclosed electromagnetic wave absorbing member may have an undefined shape such as that of a composition or a powder or may be a shaped product. For example, a shaped product of the presently disclosed electromagnetic wave absorbing member may be an electromagnetic wave absorbing member that has been shaped into a plate, sheet, or film shape.

### <<Electromagnetic wave absorbing member shaped into sheet shape>>

The following describes the presently disclosed electromagnetic wave absorbing member as a product that has been shaped into a sheet shape (hereinafter, also referred to as an "electromagnetic wave absorbing sheet").

The electromagnetic wave absorbing member that has been shaped into a sheet shape is preferably a single-layer sheet. When the electromagnetic wave absorbing member is a single-layer sheet, this enables reduction of thickness and weight of the electromagnetic wave absorbing member.

The thickness of the electromagnetic wave absorbing sheet is preferably 300 µm or less, and more preferably 200 µm or less. When the thickness of the electromagnetic wave absorbing member is not more than any of the upper limits set forth above, the electromagnetic wave absorbing member can suitably be used in mobile terminals such as smartphones and tablets, automobiles, base stations, medical devices, and various applications where space saving is necessary.

The presently disclosed electromagnetic wave absorbing sheet preferably has a configuration that includes a polymer sheet containing the polymer material and that includes the carbon nanotubes attached to the polymer sheet.

When the carbon nanotubes are said to be "attached" to the polymer sheet, this means that the carbon nanotubes are present in a state in which they are attached to or entangled with fibers that are constitutional units of the polymer sheet. In the presently disclosed electromagnetic wave absorbing sheet, it is normally preferable for the carbon nanotubes to be in an attached state not only with fibers at the surface of the polymer sheet, but also with fibers positioned inside of the polymer sheet in a thickness direction. Moreover, the presently disclosed electromagnetic wave absorbing sheet is thought to absorb electromagnetic waves particularly through carbon nanotubes that are attached to fibers positioned inside of the polymer sheet in a thickness direction attenuating incident electromagnetic waves through diffuse reflection inside of the sheet.

### [Polymer sheet]

The term "polymer sheet" as used in the present specification refers to a sheet that contains a polymer material.

Moreover, the polymer sheet is preferably non-woven fabric that is formed of polymer fibers formed of a polymer material. By using non-woven fabric, it is possible to restrict electrical conductivity and increase electromagnetic wave absorption performance.

### [Non-woven fabric]

The term "non-woven fabric" as used in the present specification refers to a "fiber sheet, web, or batt of directionally or randomly orientated fibers, bonded by at least one of entanglement, cohesion, and adhesion" as defined in JIS L 0222 (however, paper and products that are woven, knitted, tufted, or felted by milling are excluded).

### [Polymer fibers]

Organic fibers, in particular, can suitably be used as polymer fibers forming the non-woven fabric. Any of the organic fibers that were previously described in the "Organic fibers" section of "Polymer material" can be used as the organic fibers. Of these organic fibers, synthetic fibers are preferable as the organic fibers forming the non-woven fabric, and particularly Vinylon, which is an acetal derivative of polyvinyl alcohol, is more preferable.

It should be noted that carbon nanotubes are considered to not be included among the organic fibers described above.

The presently disclosed electromagnetic wave absorbing member may be a sheet that has been formed from a composition containing the polymer material and the carbon nanotubes. Moreover, the presently disclosed electromagnetic wave absorbing member can, for example, have a structure where the polymer material and the carbon nanotubes are uniformly dispersed in a sheet thickness direction, but is not specifically limited to this structure.

The sheet formed from a composition containing the polymer material and the carbon nanotubes can be produced by any known sheet formation method. Specifically, the sheet can be produced through pressing of a composition that has been obtained by mixing the polymer material, the carbon nanotubes, and other optional components.

### <Properties of electromagnetic wave absorbing member>

### <<Electrical conductivity of electromagnetic wave absorbing member>>

The electrical conductivity of the presently disclosed electromagnetic wave absorbing member is not less than 0.05 S/cm and not more than 2.0 S/cm. Moreover, the electrical conductivity of the presently disclosed electromagnetic wave absorbing member is preferably 0.1 S/cm or more. Furthermore, the electrical conductivity of the presently disclosed electromagnetic wave absorbing member is preferably 1.5 S/cm or less, and more preferably 1.0 S/cm or less. By setting the electrical conductivity of the electromagnetic wave absorbing member within any of the ranges set forth above, the electromagnetic wave absorbing member can display increased absorption capability without reflecting electromagnetic waves in a sub-terahertz frequency band of 100 GHz or higher.

Note that electrical conductivity is the reciprocal of resistivity. The electrical conductivity of the electromagnetic wave absorbing member can be controlled by, for example, adjusting the content of the CNTs in the electromagnetic wave absorbing member. For example, the electrical conductivity of the electromagnetic wave absorbing member can be increased by increasing the content of the CNTs. Conversely, the electrical conductivity of the electromagnetic wave absorbing member can be reduced by reducing the content of the CNTs.

### <<Electromagnetic wave absorption performance>>

The attenuation power ratio at a frequency of 300 GHz of the presently disclosed electromagnetic wave absorbing member is required to be 5 dB or more, and is preferably 10 dB or more.

Moreover, the attenuation power ratio is preferably 5 dB or more throughout a frequency band of not lower than 200 GHz and not higher than 300 GHz. When the attenuation power ratio is 5 dB or more throughout the frequency band set forth above, this results in even better electromagnetic wave absorption performance in a sub-terahertz frequency band.

### <Production method of electromagnetic wave absorbing member>

The presently disclosed electromagnetic wave absorbing sheet can be produced by implementing a step of filtering a dispersion liquid of the carbon nanotubes described above through a polymer sheet (filtration step), a step of stirring a dispersion liquid of the carbon nanotubes described above and a polymer sheet under a reduced pressure condition (reduced-pressure stirring step), or the like. An electromagnetic wave absorbing sheet production method such as described above enables good production of the electromagnetic wave absorbing sheet set forth above.

### <<Electromagnetic wave absorbing member production method with filtration step>>

A feature of a production method of the electromagnetic wave absorbing sheet with a filtration step is the inclusion of a filtration step of filtering a dispersion liquid of the carbon nanotubes described above through a polymer sheet.

Note that the electromagnetic wave absorbing sheet production method described above may include other steps in addition to the filtration step.

### [Filtration step]

In the filtration step, a dispersion liquid of the carbon nanotubes described above is filtered through a polymer sheet. This enables production of a primary sheet having the carbon nanotubes positioned in spaces inside of the polymer sheet in a thickness direction. Note that the obtained primary sheet can be used in that form as the presently disclosed electromagnetic wave absorbing sheet.

The dispersion liquid of carbon nanotubes (CNT dispersion liquid) can be produced by dispersing CNTs including single-walled CNTs as a main component in a dispersion medium. Examples of single-walled CNTs and other CNTs that can be used include single-walled CNTs, multi-walled CNTs, and CNT assemblies such as previously described. The dispersion medium is not specifically limited, and examples thereof include water, isopropanol, 1-methyl-2-pyrrolidone, dimethylformamide, dimethyl sulfoxide, dimethylacetamide, toluene, tetrahydrofuran, ethyl acetate, acetonitrile, ethylene glycol, methyl isobutyl ketone, and butyl alcohol. In particular, water is preferable as the dispersion medium.

A dispersant can be compounded as an additive in production of the CNT dispersion liquid in order to improve dispersibility of the CNTs in the CNT dispersion liquid. The dispersant is not specifically limited, and examples thereof include known surfactants such as sodium dodecylsulfonate, sodium deoxycholate, sodium cholate, and sodium dodecylbenzenesulfonate, and also synthetic polymers and natural polymers that can function as dispersants. The additive amount of the dispersant can be set within a typical range.

In production of the CNT dispersion liquid, the CNTs can be added to a dispersion medium having a surfactant such as described above compounded therein to obtain a crude dispersion, and then the obtained crude dispersion can be subjected to a dispersing method in which a cavitation effect is obtained and/or a dispersing method in which a crushing effect is obtained, such as disclosed in WO2014/115560A1, to thereby yield a CNT dispersion liquid having good dispersion of CNTs. Note that the dispersing method is not limited to these two methods, and a method that involves direct stirring using a stirring bar can of course also be adopted.

In production of the CNT dispersion liquid, other components such as carbon materials other than carbon nanotubes and additives can optionally be compounded in the CNT dispersion liquid. In a case in which other components are added, these components can be added to the crude dispersion of CNTs, for example.

The dispersing time in production of the CNT dispersion liquid can be set as not less than 1 minute and not more than 120 minutes, for example.

The CNT concentration in the CNT dispersion liquid is preferably 0.01 mass% or more, and more preferably 0.02 mass% or more, and is preferably 0.3 mass% or less, and more preferably 0.2 mass% or less. When the CNT concentration in the CNT dispersion liquid is within any of the ranges set forth above, the CNTs can be caused to efficiently enter spaces inside of the polymer sheet in a thickness direction during the subsequently described filtration step. As a result, it is possible to obtain an electromagnetic wave absorbing sheet that is homogeneous and has even better electromagnetic wave absorption performance in a sub-terahertz frequency band.

The obtained CNT dispersion liquid is preferably degassed before being filtered through the polymer sheet. By filtering the CNT dispersion liquid using the polymer sheet after degassing of the CNT dispersion liquid, it is easy to cause the CNTs to enter spaces inside of the polymer sheet in a thickness direction.

No specific limitations are placed on the method by which the CNT dispersion liquid is degassed, and a method using a known degassing device can be adopted. In particular, a method using a reduced-pressure stirring device (vacuum stirring device) is preferable from a viewpoint of achieving good degassing while also inhibiting aggregation of the CNTs in the CNT dispersion liquid.

No specific limitations are placed on the method by which the carbon nanotube dispersion liquid is filtered using the polymer sheet, and a known filtration method such as natural filtration, vacuum filtration (suction filtration), pressurized filtration, or centrifugal filtration can be adopted. From a viewpoint of causing simple and good entry of the CNTs into spaces inside of the polymer sheet in a thickness direction, the filtration method is preferably vacuum filtration (suction filtration) or pressurized filtration, and more preferably vacuum filtration (suction filtration).

Note that conditions such as pressure in the vacuum filtration (suction filtration) or pressurized filtration can be freely set according to the desired surface roughness of a main surface of the resulting electromagnetic wave absorbing sheet, for example.

The polymer sheet that is used in the filtration step can be the non-woven fabric formed of polymer fibers that was previously described in the "Electromagnetic wave absorbing member shaped into sheet shape" section, for example.

The basis weight of the polymer sheet is preferably 4 g/m² or more, and more preferably 8 g/m² or more, and is preferably 150 g/m² or less, and more preferably 120 g/m² or less. When the basis weight of the polymer sheet is not less than any of the lower limits set forth above, electromagnetic wave absorption performance of the produced electromagnetic wave absorbing sheet in a sub-terahertz frequency band can be further increased, and sufficiently high mechanical strength of the electromagnetic wave absorbing sheet can be ensured. On the other hand, when the basis weight of the polymer sheet is not more than any of the upper limits set forth above, the weight of the produced electromagnetic wave absorbing sheet can be reduced.

The thickness of the polymer sheet is preferably 5 µm or more, and is preferably 500 µm or less, and more preferably 400 µm or less. When the thickness of the polymer sheet is not less than the lower limit set forth above, electromagnetic wave absorption performance of the produced electromagnetic wave absorbing sheet in a sub-terahertz frequency band can be further increased, and sufficiently high mechanical strength of the electromagnetic wave absorbing sheet can be ensured. On the other hand, when the thickness of the polymer sheet is not more than any of the upper limits set forth above, the thickness and weight of the produced electromagnetic wave absorbing sheet can be reduced.

### [Other steps]

The production method of the presently disclosed electromagnetic wave absorbing sheet described above may include other steps besides the filtration step described above. Examples of such other steps include a dispersion medium removal step and a drying step but are not specifically limited thereto.

### {Dispersion medium removal step}

In the dispersion medium removal step, the dispersion medium in the dispersion liquid of the carbon nanotubes is removed from the polymer sheet to which the dispersion liquid has become attached through the filtration step described above. Implementation of the dispersion medium removal step enables even better production of the electromagnetic wave absorbing sheet.

No specific limitations are placed on the method by which the dispersion medium in the dispersion liquid of the carbon nanotubes is removed from the polymer sheet to which the dispersion liquid has become attached. For example, the dispersion medium can be washed by pouring isopropyl alcohol onto the polymer sheet after the filtration step and then performing filtration, such as by suction filtration described above in the "Filtration step" section.

Conditions such as substances, amounts, and filtration pressure can be freely set.

### {Drying step}

In the drying step, the electromagnetic wave absorbing sheet can be obtained through drying of the primary sheet. Although a dispersion medium and solvent used in previously described steps can be present in the primary sheet, it is possible to reduce the residual amount of the solvent in the obtained electromagnetic wave absorbing sheet by performing the dispersion medium removal step described above or by drying the primary sheet.

Examples of drying methods that may be used include, but are not specifically limited to, hot-air drying, vacuum drying, hot-roll drying, and infrared irradiation. Although no specific limitations are placed on the drying temperature and the drying time, the drying temperature is normally from room temperature to 200°C, and the drying time is normally not less than 1 hour and not more than 48 hours.

Note that in the production method of the presently disclosed electromagnetic wave absorbing sheet, the polymer sheet may shrink as a result of heating in the drying step, for example. Accordingly, the polymer sheet prior to use in the production method of the electromagnetic wave absorbing sheet and the polymer sheet that is included in the electromagnetic wave absorbing sheet obtained by this production method may differ in terms of basis weight, thickness, fineness of organic fibers, and so forth.

### <<Electromagnetic wave absorbing sheet production method with reduced-pressure stirring step>>

A feature of a production method of the presently disclosed electromagnetic wave absorbing sheet with a reduced-pressure stirring step is the inclusion of a step of stirring a dispersion liquid of the carbon nanotubes described above and a polymer sheet under a reduced-pressure condition.

Note that the production method of the presently disclosed electromagnetic wave absorbing sheet described above may include other steps besides the reduced-pressure stirring step.

### [Reduced-pressure stirring step]

In the reduced-pressure stirring step, a dispersion liquid containing the carbon nanotubes described above and a polymer sheet are stirred under a reduced-pressure condition. This yields a polymer sheet having the dispersion liquid of the carbon nanotubes attached thereto.

The reduced-pressure stirring step can be performed by, for example, loading the dispersion liquid of the carbon nanotubes described above and the polymer sheet into the same vessel and performing stirring thereof under a reduced-pressure condition using a known reduced-pressure stirring device (vacuum stirring device).

The dispersion liquid of the carbon nanotubes can be the CNT dispersion liquid that was previously described in the "Filtration step" section, for example.

The polymer sheet can be the non-woven fabric formed of polymer fibers that was previously described in the "Electromagnetic wave absorbing member shaped into sheet shape" section, for example.

Note that the reduced-pressure condition, etc. during stirring can be set as appropriate within a range where the desired effects according to the present disclosure are obtained.

### [Other steps]

The production method of the presently disclosed electromagnetic wave absorbing sheet described above may include other steps besides the reduced-pressure stirring step described above. Examples of such other steps include a dispersion medium removal step but are not specifically limited thereto.

### {Dispersion medium removal step}

In the dispersion medium removal step, the dispersion medium in the dispersion liquid of the carbon nanotubes is removed from the polymer sheet to which the dispersion liquid has become attached through the reduced-pressure stirring step described above. Implementation of the dispersion medium removal step enables even better production of the electromagnetic wave absorbing sheet.

No specific limitations are placed on the method by which the dispersion medium in the dispersion liquid of the carbon nanotubes is removed from the polymer sheet to which the dispersion liquid has become attached. A filtration method such as suction filtration previously described in the "Filtration step" section, a washing method such as previously described in the "Dispersion medium removal step" section, or a drying method such as previously described in the "Drying step" section can be used, and these methods may also be used in combination.

### EXAMPLES

The following provides a more specific description of the present disclosure based on examples. However, the present disclosure is not limited to the following examples. Various measurements in the examples and comparative examples were performed by the following methods.

### (Measurement of physical properties)

### <BET specific surface area of CNTs>

The nitrogen adsorption specific surface area of carbon nanotubes used in each example or comparative example was measured in accordance with the BET method using a BELSORP^{®}-mini (produced by Bel Japan Inc.).

### <G/D ratio of CNTs>

A Raman spectrum of carbon nanotubes was measured using a microscopic laser Raman spectrophotometer (microscopic Raman spectroscopy system SENTERRA produced by Bruker). In the obtained Raman spectrum, the intensity of a G band peak observed near 1590 cm⁻¹ and the intensity of a D band peak observed near 1340 cm⁻¹ were determined, and the G/D ratio was calculated.

### <Effective length of CNTs>

Water containing sodium dodecylbenzenesulfonate as a surfactant in a concentration of 1 mass% was added, in an amount of 100 g, to 10 mg of CNTs as a material prepared in each example or comparative example and was subjected to 1 minute of stirring at 45 Hz using an ultrasonic bath so as to obtain 100 mL of a dispersion liquid of each CNT assembly. Each dispersion liquid produced as described above was diluted two fold using solvent of the same composition, the diluted dispersion liquid was dripped onto a silicon substrate and dried, and then a Fourier-transform infrared spectrophotometer was used to measure the effective length through a plasmon far-infrared (FIR) resonance peak.

### <Production of buckypaper (BP) for use in measurement of CNT electrical conductivity>

A dispersion liquid was obtained by adding 20 g of ethanol to 20 mg of CNTs and performing 1 minute of dispersing using an ultrasonic disperser. All of this dispersion liquid was dripped and filtered so as to produce ϕ38 mm buckypaper.

### <Electrical conductivity of CNTs>

The electrical conductivity of CNTs was measured in accordance with JIS K 7194 by a four-terminal method performed with probes arranged on one side of the buckypaper using a resistivity meter for low resistance (Loresta^{®} GX (Loresta is a registered trademark in Japan, other countries, or both) produced by Mitsubishi Chemical Analytech Co., Ltd.).

### <CNT content of electromagnetic wave absorbing sheet>

The content of CNTs in an electromagnetic wave absorbing sheet was calculated by the following method. Specifically, the electromagnetic wave absorbing sheet was cut out as 5 cm × 5 cm (area: 25 cm²) to obtain a test specimen, and the mass W^{s} (mg) of this test specimen was weighed. The total attached amount W^{CNT} (mg) of CNTs was then determined by subtracting the mass W^{f} (mg) of a polymer sheet that had been used to produce the electromagnetic wave absorbing sheet, and this amount W^{CNT} was divided by the area of the test specimen to calculate the content (mg/cm²) of CNTs as the attached amount (mg) per 1 cm² of the test specimen.

### <Thickness of electromagnetic wave absorbing sheet>

The thickness of an electromagnetic wave absorbing sheet produced in each example or comparative example was measured using a Digimatic Outside Micrometer produced by Mitutoyo Corporation.

### <Electrical conductivity of electromagnetic wave absorbing sheet>

The electrical conductivity of an electromagnetic wave absorbing sheet produced in each example or comparative example was calculated by, in accordance with JIS K 7194, implementing a four-probe method performed with probes arranged on one side of the electromagnetic wave absorbing sheet using a resistivity meter for low resistance (Loresta^{®} GX produced by Mitsubishi Chemical Analytech Co., Ltd.).

### <Electromagnetic wave absorption performance of electromagnetic wave absorbing sheet>

With respect to an electromagnetic wave absorbing sheet produced in each example or comparative example, absorbance was measured by transmission measurement in terahertz time-domain spectroscopy (THz-TDS), and the absorption attenuation (dB) at a frequency of 300 GHz was measured. Note that the used measurement instrument and measurement frequency were as follows.

Measurement instrument: Terahertz Spectrometer Tera Prospector produced by Nippo Precision Co., Ltd.

Measurement frequency: Not lower than 200 GHz and not higher than 3 THz

Note that a larger transmission attenuation power ratio at a given frequency indicates that the electromagnetic wave absorbing sheet has better electromagnetic wave absorption performance at that frequency.

Electromagnetic wave absorbing members in examples according to the present application were confirmed to have an attenuation power ratio of 5 dB or more throughout a frequency band of not lower than 200 GHz and not higher than 300 GHz according to the method described above.

### (Example 1)

### <Preparation of CNT assembly>

An SGCNT assembly (hereinafter, also referred to as CNT1) that was used in Example 1 was produced by a method where, in a CNT synthesis step, a particulate catalyst-bearing support was continuously conveyed by screw rotation while supplying a source gas.

### <Catalyst layer formation step>

Zirconia (zirconium dioxide) beads (ZrO₂; volume-average particle diameter D50: 650 µm) serving as a substrate were loaded into a rotary drum-type coating apparatus. The zirconia beads were stirred (20 rpm) while spraying an aluminum-containing solution by a spray gun (spraying rate: 3 g/min; spraying time: 940 s; spraying air pressure: 10 MPa), and drying was performed while supplying compressed air (300 L/min) into the rotary drum to form an aluminum-containing coating film on the zirconia beads. Next, firing treatment was performed at 480°C for 45 minutes to produce primary catalyst particles on which an aluminum oxide layer had been formed. Moreover, these primary catalyst particles were loaded into a separate rotary drum-type coating apparatus, were stirred (20 rpm) while spraying an iron catalyst solution by a spray gun (spraying rate: 2 g/min; spraying time: 480 s; spraying air pressure: 5 MPa), and were dried while supplying compressed air (300 L/min) into the rotary drum so as to form an iron-containing coating film on the primary catalyst particles. Next, firing treatment was performed at 220°C for 20 minutes to produce a substrate having an iron oxide layer further formed thereon.

### <CNT synthesis step>

The substrate having a catalyst at the surface that was produced in this manner was loaded into a feeder hopper of a production apparatus and was subjected to a formation step, a growth step, and a cooling step in this order while being conveyed by a screw conveyer so as to produce a CNT assembly.

### <<Formation step to cooling step>>

Conditions of an inlet purge device, a formation unit, a gas intrusion prevention device, a growth unit, an outlet purge device, and a cooling unit of the CNT assembly production apparatus were set as follows.

Feeder hopper
- Feed rate: 1.25 kg/h
- Exhaust rate: 10 sLm (natural exhaust from gaps)

Inlet purge device
   - Purge gas: Nitrogen 40 sLm
Formation unit
   - Furnace internal temperature: 800°C
   - Reducing gas: Nitrogen 6 sLm, hydrogen 54 sLm
   - Exhaust rate: 60 sLm
   - Processing time: 20 minutes
Gas intrusion prevention device
   - Purge gas: 20 sLm
   - Exhaust rate of exhauster: 62 sLm
Growth unit
   - Furnace internal temperature: 830°C
   - Source gas: Nitrogen 15 sLm, ethylene 5 sLm, carbon dioxide 1 sLm, hydrogen 3 sLm
   - Exhaust rate: 47 sLm
   - Processing time: 10 minutes
Outlet purge device
   - Purge gas: Nitrogen 45 sLm
Cooling unit
   - Cooling temperature: Room temperature
   - Exhaust rate: 10 sLm (natural exhaust from gaps)

Continuous production was performed under the conditions listed above.

### <Separation and recovery step>

The CNT assembly synthesized on the substrate was separated and recovered using a forced vortex classifier (rotation speed: 2,300 rpm; air flow rate: 3.5 Nm³/min). The recovery rate of the CNT assembly was 96%.

Characteristics of the CNT assembly produced in this example, in terms of representative values, were a tapped bulk density of 0.02 g/cm³, a CNT average length of 150 µm, a BET specific surface area of 902 m²/g, an average diameter of 4.0 nm, and a carbon purity of 99%.

### <Production of CNT dispersion liquid>

A 0.4 mass% aqueous solution of sodium dodecyl sulfate (SDS) was produced using 80 mg of SDS (produced by FUJIFILM Wako Pure Chemical Corporation) as a dispersant and 19,900 mg of water as a dispersion medium. Next, 20 mg of the SGCNTs produced as described above as single-walled CNTs were added to this solution to obtain a crude dispersion containing SDS as a dispersant. This crude dispersion containing single-walled CNTs was loaded into a disperser (Nano Premixer produced by Thinky Corporation) and was subjected to ultrasonic dispersing treatment with a power of 150 W over 60 minutes so as to disperse the CNTs and obtain an SGCNT dispersion liquid of 0.1 mass% in concentration.

### <Filtration step>

Vinylon non-woven fabric (produced by Kuraray Co., Ltd.; product no.: BFN No. 3; basis weight: 36 g/m²; thickness: 123 µm) as a polymer sheet of 5 cm × 10 cm was set in a suction filter, and 2 g of the 0.1 mass% SGCNT dispersion liquid obtained as described above was dripped thereon. Suction filtration was performed until the dispersion liquid had completely disappeared, and then atmospheric release was performed, thereby yielding a primary sheet.

### <Dispersion medium removal step>

After the filtration step, 50 mL of isopropyl alcohol (IPA) was poured onto the primary sheet, suction filtration was performed in the same way as in the filtration step until the IPA had completely disappeared, and then atmospheric release was performed. Thereafter, 100 mL of water was poured onto the primary sheet, and suction filtration was performed once again in the same manner. After the suction filtration, the primary sheet was left for one hour before atmospheric release, and then the primary sheet was removed.

### <Drying step>

The primary sheet present after the filtration step and the dispersion medium removal step described above was vacuum dried at a temperature of 150°C over 12 hours to obtain an electromagnetic wave absorbing sheet. Various measurements were performed with respect to the obtained electromagnetic wave absorbing sheet by the previously described methods. The results are shown in Table 1.

### (Examples 2 and 3)

Various operations and measurements were performed in the same way as in Example 1 with the exception that the type of SGCNTs was changed to ZEONANO^{®} SG101 (ZEONANO is a registered trademark in Japan, other countries, or both; produced by Zeon Corporation; BET specific surface area: 1,250 m²/g; average diameter: 3.3 nm; average length: 400 µm; t-plot having convex upward shape (bending point position: 0.6 nm)), and the dripped amount of the CNT dispersion liquid was set as 2 g in Example 2, 6 g in Example 3, and 8 g in Example 4. The results are shown in Table 1.

### (Comparative Examples 1 to 3)

Various operations and measurements were performed in the same way as in Example 1 with the exception that the type of CNTs was changed to NC7000 (product name; produced by Nanocyl) in Comparative Example 1, eDIPS (product name; produced by Meijo Nano Carbon) in Comparative Example 2, and Tuball (product name; produced by OCSiAl) in Comparative Example 3, and the dripped amount of the CNT dispersion liquid was set as 6 g in Comparative Example 1 and Comparative Example 2 and as 1 g in Comparative Example 3. The results are shown in Table 1.

**[Table 1]**

| | | Example 1 | Example 2 | Example 3 | Example 4 | Comparative Example 1 | Comparative Example 2 | Comparative Example 3 |
|---|---|---|---|---|---|---|---|---|
| Physical properties of CNTs | Type of CNTs | CNT1 | SG101 | SG101 | SG101 | NC7000 | eDIPS | Tuball |
| | | Single-walled | Single-walled | Single-walled | Single-walled | Multi-walled | Single-walled | Single-walled |
| | BET specific surface area (m²/g) | 902 | 1250 | 1250 | 1250 | 300 | 637 | 1037 |
| | G/D ratio | 1.4 | 3.0 | 3.0 | 3.0 | 0.9 | 241 | 108 |
| | Effective length (nm) | 100 | 200 | 200 | 200 | Not detected | 2100 | 1200 |
| | Electrical conductivity of BP (S/cm) | 25 | 35 | 35 | 35 | 5 | 500 | 1100 |
| Physical properties of electromagnetic wave absorbing sheet | Electrical conductivity (S/cm) | 0.1 | 0.1 | 0.6 | 1.0 | 0.2 | 330 | 0.1 |
| | Film thickness (µm) | 120 | 197 | 197 | 132 | 72 | 78 | 130 |
| | Electromagnetic wave absorption performance (attenuation power ratio) at frequency of 300 GHz (dB) | 7 | 10 | 13 | 15 | 3 | 0 | 0 |
| | Attached amount A of CNTs in electromagnetic wave absorbing sheet (mg) | 2 | 2 | 6 | 8 | 6 | 6 | 1 |
| | Index value I = C (S/cm) × A (mg) | 50 | 70 | 210 | 280 | 30 | 3000 | 1100 |

It can be seen from the results in Table 1 that in Examples 1 to 3 in which a polymer material and carbon nanotubes including single-walled carbon nanotubes as a main component are included and in which the electrical conductivity of an electromagnetic wave absorbing member is not less than 0.1 S/cm and not more than 2.0 S/cm, the attenuation power ratio of electromagnetic waves at 300 GHz is 5 dB or more in each example, and the electromagnetic wave absorption performance in a sub-terahertz frequency band is excellent.

### INDUSTRIAL APPLICABILITY

According to the present disclosure, it is possible to provide an electromagnetic wave absorbing member having excellent electromagnetic wave absorption performance in a sub-terahertz frequency band of 100 GHz or higher.

## Claims

1. An electromagnetic wave absorbing member for a sub-terahertz frequency band of 100 GHz or higher comprising a polymer material and carbon nanotubes, wherein
the carbon nanotubes include single-walled carbon nanotubes as a main component, and
the electromagnetic wave absorbing member has an electrical conductivity of not less than 0.1 S/cm and not more than 2.0 S/cm and has an attenuation power ratio of 5 dB or more at a frequency of 300 GHz.

2. The electromagnetic wave absorbing member according to claim 1, wherein
an attached amount of the carbon nanotubes is A, in units of mg,
an electrical conductivity of the carbon nanotubes is C, in units of S/cm, and
an index value I determined according to formula (1), shown below: $I = C \times A$ is not less than 40 and not more than 500.

3. The electromagnetic wave absorbing member according to claim 1 or 2, wherein the electromagnetic wave absorbing member is formed with a single-layer sheet shape.

4. The electromagnetic wave absorbing member according to claim 3, wherein the electromagnetic wave absorbing member has a thickness of 300 µm or less.

5. The electromagnetic wave absorbing member according to claim 3, wherein the electromagnetic wave absorbing member has a configuration that includes a polymer sheet containing the polymer material and that includes the carbon nanotubes attached to the polymer sheet.

6. The electromagnetic wave absorbing member according to claim 3, wherein the electromagnetic wave absorbing member is a sheet that has been formed from a composition containing the polymer material and the carbon nanotubes.

7. The electromagnetic wave absorbing member according to claim 5, wherein the polymer sheet is non-woven fabric that has been formed using polymer fibers formed of the polymer material.

8. The electromagnetic wave absorbing member according to claim 1 or 2, wherein the carbon nanotubes have a G/D ratio of 4.0 or less.

9. The electromagnetic wave absorbing member according to claim 1 or 2, wherein the carbon nanotubes have a BET specific surface area of 600 m²/g or more.

10. The electromagnetic wave absorbing member according to claim 1 or 2, wherein the carbon nanotubes have an effective length of not less than 40 nm and not more than 1,000 nm.

11. The electromagnetic wave absorbing member according to claim 1 or 2, wherein the electromagnetic wave absorbing member has an attenuation power ratio of 5 dB or more throughout a frequency band of not lower than 200 GHz and not higher than 300 GHz.
